# EUROPEAN PATENT APPLICATION

(11) **EP 2 772 932 A1**
(43) Date of publication of application: **03.09.2014**
(21) Application number: 13185522.3
(22) Date of filing: 23.09.2013
(51) Int. Cl.: H01J 37/34, H01J 37/32

(54) **In-situ sputtering apparatus**

(30) Priority: 01.03.2013 US 201313782270; 15.03.2013 US 201313837756
(71) Applicant: Poole Ventura, Inc., Oxnard, CA 93730 (US); Brookhaven Science Associates LLC, Upton, New York 11973-5000 (US)
(72) Inventor: Erickson, Mark, Newbury Park, CA 91320 (US); Poole, Henry, Ventura, CA 93001 (US); Custer, Arthur, Ventura, CA 93003 (US); Hershcovitch, Ady, Upton, NY 11973 (US); Jamshidi, Nader, Newbury Park, CA 91320 (US)
(74) Representative: Walker, Ross Thomson

(57) **Abstract**

A sputtering apparatus that includes at least a target presented as an inner surface of a confinement structure, the inner surface of the confinement structure is preferably an internal wall of a circular tube. A cathode is disposed adjacent the internal wall of the circular tube. The cathode preferably provides a hollow core, within which a magnetron is disposed. Preferably, an actuator is attached to the magnetron, wherein a position of the magnetron within the hollow core is altered upon activation of the actuator. Additionally, a carriage supporting the cathode and communicating with the target is preferably provided, and a cable bundle interacting with the cathode and linked to a cable bundle take up mechanism provides power and coolant to the cathode, magnetron, actuator and an anode of the sputtering apparatus.

## Description

### Related Application

This application is a continuation-in-part of copending U.S. Patent Application No. 13/782,270 filed on March 1, 2013 entitled, "In-Situ Sputtering Apparatus."

### Field of the Invention

The claimed invention relates to the field of in-situ sputtering apparatus and methods of using same for cold bore tubes, and more particularly to sputtering apparatus and methods of coating the inner bore of stainless steel tubes.

### Summary of the Invention

The present disclosure relates to in-situ sputtering apparatus and methods of using same for cold bore tubes, and more particularly to sputtering apparatus and methods of coating the inner bore of stainless steel tubes.

In accordance with various exemplary embodiments, a sputtering apparatus includes at least a target presented as an inner surface of a confinement structure, a cathode adjacent the target, wherein the cathode provides a hollow core. Preferably, the inner surface of the confinement structure is an internal wall of a circular tube, and the hollow core of the cathode provides space for a magnetron disposed within the hollow core. The sputtering apparatus further preferably includes an actuator communicating with the magnetron, wherein a position of the magnetron within the hollow core is altered upon activation of the actuator. In a preferred embodiment, a carriage supporting the cathode and communicating with the target is provided to facilitate translation of the magnetron within the cathode, and a cable bundle interacting with the cathode provides power and coolant to the cathode. Still further, the sputtering apparatus preferably includes in the exemplary embodiment, a cable bundle take up mechanism secured to the cable bundle on an end of the cable bundle distal from the end of the cable bundle communicating with the cathode.

In an alternate exemplary embodiment, a sputtering apparatus includes at least a target presented as an inner surface of a confinement structure, a cathode adjacent the target, wherein the cathode provides a hollow core. Preferably, the inner surface of the confinement structure is an internal wall of a circular tube, and the hollow core of the cathode provides space for a magnetron disposed within the hollow core. The sputtering apparatus further preferably includes an actuator communicating with the magnetron, wherein a position of the magnetron within the hollow core is altered upon activation of the actuator. In a preferred embodiment, a carriage supporting the cathode and communicating with the target is provided to facilitate translation of the magnetron within the cathode, and a cable bundle interacting with the cathode provides power and coolant to the cathode. Still further, the sputtering apparatus preferably includes in the exemplary embodiment, a cable bundle take up mechanism secured to the cable bundle on an end of the cable bundle distal from the end of the cable bundle communicating with the cathode, and in which the magnetron includes at least a plurality of magnets, each of the plurality of magnets having a pair of substantially parallel external side surfaces, a main body portion disposed between the pair of substantially parallel external side surfaces, the main body portion having an external surface disposed between and substantially non-perpendicular to the pair of substantially parallel external surfaces, and wherein the actuator rotates the magnetron relative to the cathode.

These and various other features and advantages that characterize the claimed invention will be apparent upon reading the following detailed description and upon review of the associated drawings.

### Brief Description of the Drawings

The patent or application file contains at least one drawing executed in color. Copies of this patent with color drawing(s) will be provided by the Patent and Trademark Office upon request and payment of necessary fee.
- FIG. 1: displays an orthogonal projection of an exemplary embodiment of a sputtering apparatus of the claimed invention.
- FIG. 2: provides an orthogonal projection of an exemplary carriage of the sputtering apparatus of FIG. 1.
- FIG. 3: shows an orthogonal projection of an exemplary embodiment of an in-line plurality sputtering apparatus of the claimed invention of FIG. 1.
- FIG. 4: illustrates an orthogonal projection of a pair of exemplary carriages of the sputtering apparatus of FIG. 3.
- FIG. 5: provides a side view in elevation of the sputtering apparatus of FIG. 1.
- FIG. 6: displays an end view in elevation of the sputtering apparatus of FIG. 5.
- FIG. 7: shows a cross section end view in elevation of the sputtering apparatus of FIG. 5.
- FIG. 8: illustrates a cross section view in elevation of the sputtering apparatus of FIG. 5.
- FIG. 9: provides an alternate cross section view in elevation of the sputtering apparatus of FIG. 5.
- FIG. 10: displays an orthogonal projection of an exemplary embodiment of a sputtering apparatus of FIG. 5.
- FIG. 11: shows an orthogonal projection of a cable bundle take up mechanism, configured to cooperate with the sputtering apparatus of FIG. 3.
- FIG. 12: illustrates a partial cross section in an orthogonal projection of the exemplary embodiment of a sputtering apparatus of FIG. 1, communicating with a target of the claimed invention.
- FIG. 13: provides a partial cross section in an orthogonal projection of the exemplary embodiment of a sputtering apparatus of FIG. 1, communicating with a preferred actuator of the claimed invention.
- FIG. 14: displays a partial cross section in an orthogonal projection of the exemplary embodiment of a sputtering apparatus of FIG. 1, communicating with an alternate preferred actuator of the claimed invention.
- FIG. 15: shows a cross section view in an orthogonal projection of an alternate preferred embodiment of a magnetron of the sputtering apparatus of FIG. 1.
- FIG. 16: illustrates a cross section view in an orthogonal projection of the alternate preferred embodiment of the magnetron of the sputtering apparatus of FIG. 15, communicating with an alternative preferred actuator of the claimed invention.
- FIG. 17: provides an alternate preferred embodiment of an inventive sputtering apparatus.
- FIG. 18: displays a partial cutaway view in elevation of the inventive sputtering apparatus of FIG. 17.
- FIG. 19: shows a partial cutaway, cross-section view in elevation of the inventive sputtering apparatus of FIG. 18.
- FIG. 20: illustrates a cross-section view in elevation of the inventive sputtering apparatus of FIG. 17.
- FIG. 21: provides a partial cross-section view in elevation of a section of the inventive sputtering apparatus of FIG. 20.
- FIG. 22: displays a partial cross-section view in elevation of a section of the inventive sputtering apparatus of FIG. 20.
- FIG. 23: shows a partial cross-section view in an orthogonal projection of the inventive sputtering apparatus of FIG. 21.
- FIG. 24: illustrates a partial cross-section view in an orthogonal projection of the inventive sputtering apparatus of FIG. 22.

### Detailed Description of an Exemplary Embodiment of the Drawings

Reference will now be made in detail to one or more examples of various embodiments of the present invention depicted in the figures. Each example is provided by way of explanation of the various embodiments of the present invention, and not meant as a limitation of the invention. For example, features illustrated or described as part of one embodiment may be used with another embodiment to yield still a different embodiment. Other modifications and variations to the described embodiments are also contemplated within the scope and spirit of the claimed invention.

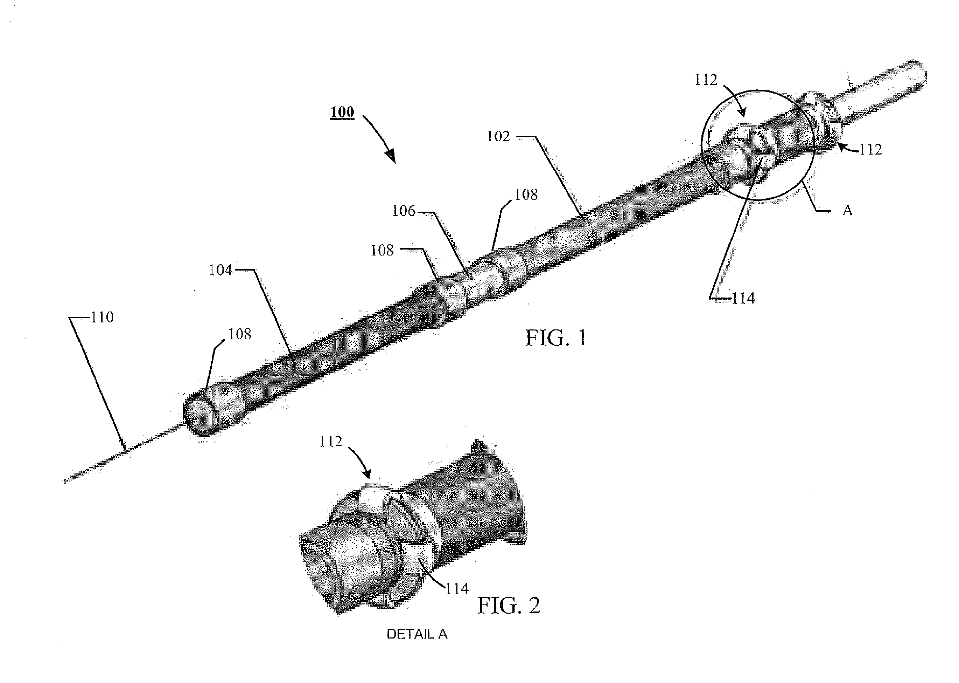

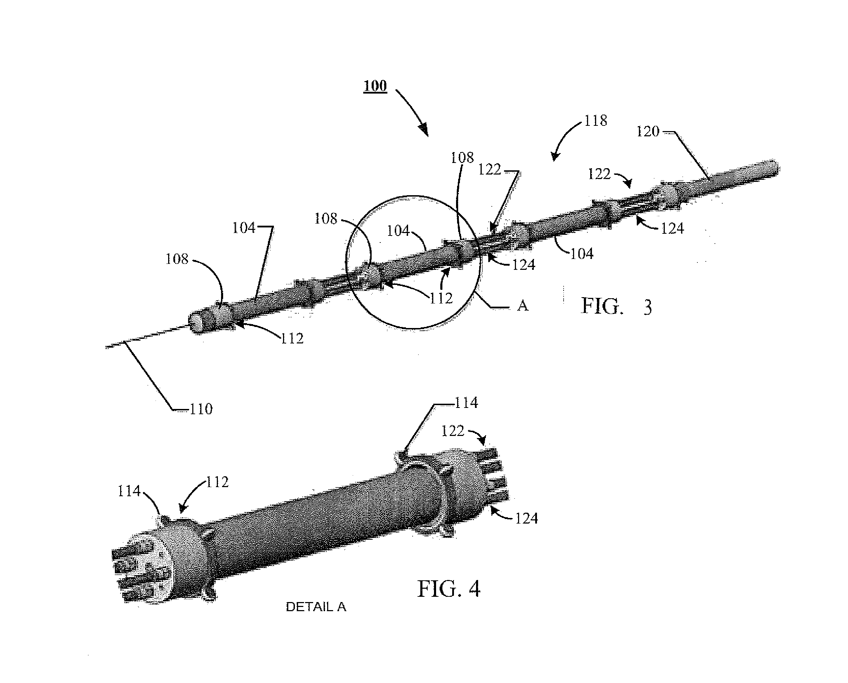

Turning to the drawings, FIG. 1 displays an exemplary sputtering apparatus 100 which includes at least a first cathode 102, preferably formed from copper, a second cathode 104, preferably formed from graphite, an insulator 106 disposed between the graphite and copper cathodes (102, 104), and a plurality of anodes 108. In a preferred embodiment, the sputtering apparatus 100 further includes an attached drag line 110 adjacent an end anode 108, and a carriage 112. Preferably, the carriage 112 provides a plurality of rotational mechanisms 114, which may take the form of crowned rollers, as shown by FIG. 2, or wheels as shown by FIG. 4, supported by a carriage 112, and in turn supporting a process chamber 106.

FIG. 3 shows an exemplary alternate embodiment, which includes a plurality of cathode and anode pairs 118, strung together in a linear fashion, a conduit bundle 120 secured to a proximal end of the plurality of cathode and anode pairs 118, and the attached drag line 110 adjacent an end anode 108, on the distal end of the plurality of cathode and anode pairs 118. In a preferred embodiment, the conduit bundle 120 (also referred to herein as cable bundle 120) houses at least power leads 122 and coolant lines 124, which are visibly shown disposed between each of the pairs of the plurality of cathode and anode pairs 118. FIG. 3 further shows a plurality of carriages 112, each adjacent the plurality of anodes 108.

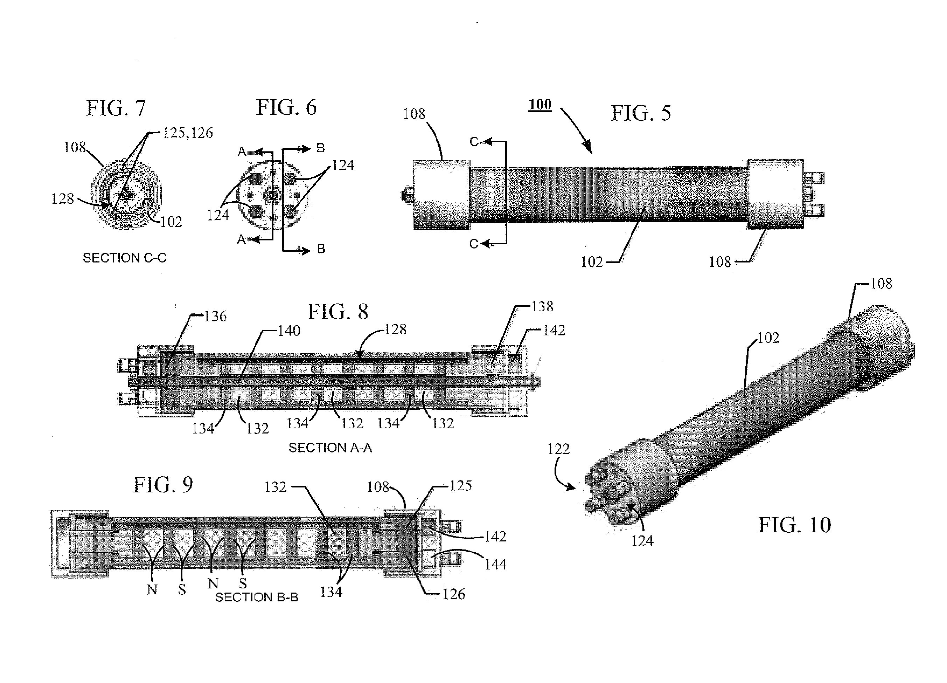

The cross-sectional, front view of the sputtering apparatus 100 shown by FIG. 5 provides a more detailed depiction of inlet and outlet coolant channels (125, 126) formed between a magnet assembly 128 (of FIG. 8), and the cathode 102, while FIG. 6 shows an end view in elevation, delineating the power leads 122, from the coolant lines 124. FIG. 7 provides a side view in elevation, and reference of orientation for the section view C-C, shown by FIG. 5. FIG. 6 further provides a reference for section view A-A, of FIG. 8, and section view B-B of FIG. 9 respectively, and FIG. 10 provides perspective view of the power leads 122, and the coolant lines 124, relative to the anode 108.

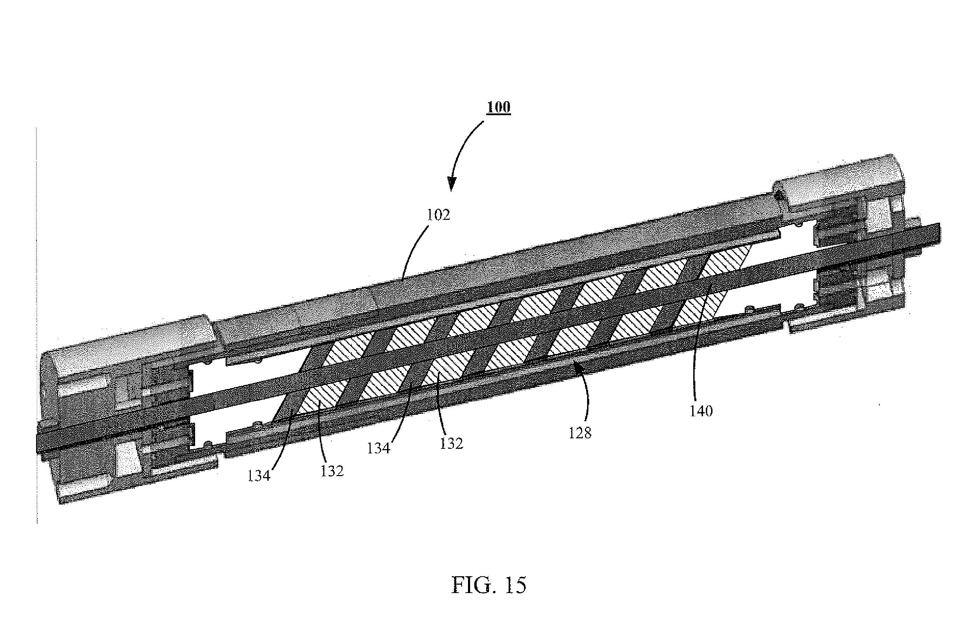

Returning to FIG. 8, shown therein is the magnet assembly 128, which includes at least a plurality of insulators 132, disposed between a plurality of magnets 134. Preferably, each of the plurality of magnets 134 are arranged such that the faces of adjacent magnets have common polarities, i.e., north to north, and south to south, as depicted in FIG. 9, which helps focus the magnetic flux field. FIG. 8 further shows that the magnet assembly 128 preferably includes a front cap 136, an end cap 138, and a draw bolt 140 extending through the plurality of magnets 134 and the plurality of insulators 132. In a preferred embodiment, the draw bolt 140, maintains the faces of the adjacent magnets 134, substantially perpendicular to the cathode 102, as shown by FIG. 8, while in an alternate preferred embodiment, the draw bolt 140, maintains the faces of the adjacent magnets 134, substantially non-perpendicular to the cathode 102, as shown by FIG. 15. Preferably, the adjacent magnets 134, shown in both FIGS. 8 and 15, have circular face, the adjacent magnets 134 shown by FIG. 15 are aligned such that the circular faces are non-perpendicular relative to the draw bolt 140, and cathode 102.

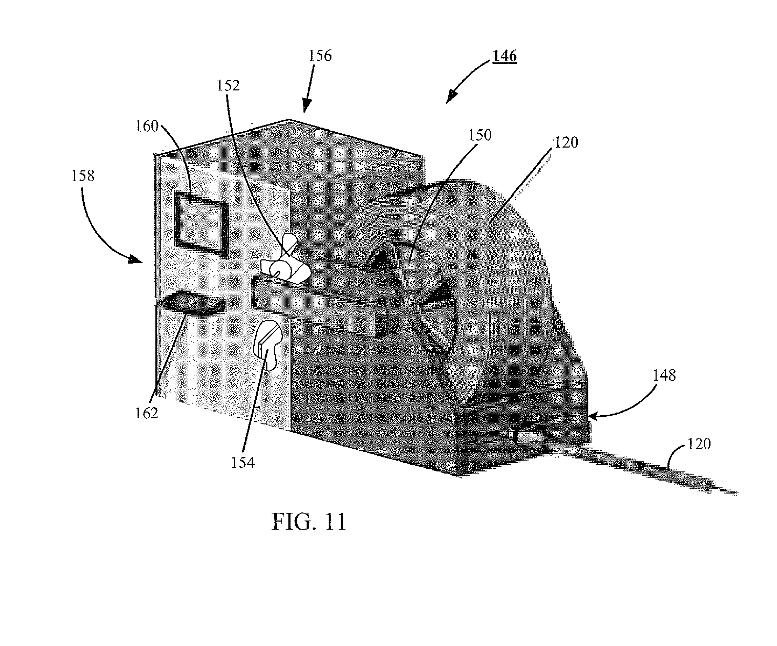

Continuing with FIGS. 9 and 11, in a preferred embodiment, shown by FIG. 9, the anode 108 provides an inlet coolant cavity 144 communicating with the inlet coolant channel 125, and an outlet coolant cavity 142 communicating with the outlet coolant channel 126. In a preferred embodiment, shown by FIG. 11, the sputtering apparatus 100 further includes at least a cable bundle take up mechanism 146, secured to the cable bundle 120. The cable bundle take up mechanism 146 preferably includes at least: a conduit guide and tensioning mechanism 148, cooperating with the cable bundle 120; a spool 150 communicating with the cable bundle 120; a motor 152 cooperating with the spool 150; a motor controller 154 communicating with the motor 152; a cabinet 156 housing the motor 152, the motor controller 154, and the spool 150; and an operator interface 158, including at least a monitor 160 and keyboard 162, interfacing with the motor controller 154.

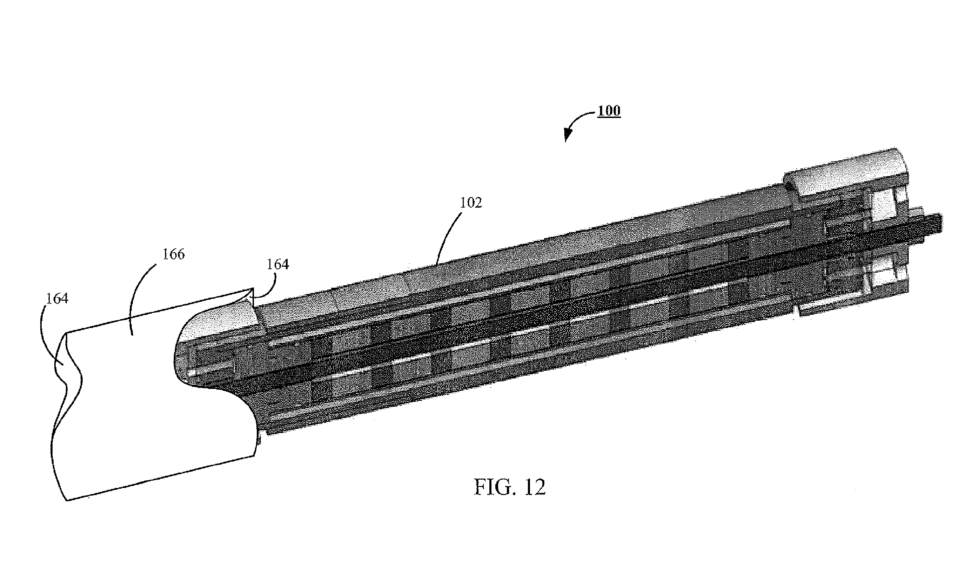

FIG. 12 shows the sputtering apparatus 100 includes a target 164, which preferably is an inner surface of an elongated confinement structure 166 having a cylindrical shape. Any geometric shape of the elongated confinement structure 166 is suitable for interaction with the cathode 102. For example, the geometric shape of the elongated confinement structure 166 may be a rectangular cylinder, a hexagonal cylinder, a trapezoidal cylinder, a triangular cylinder, an octagonal cylinder, or other shape. However, in a preferred embodiment, the geometric shape of the elongated confinement structure 166 is cylinder having a circular cross section.

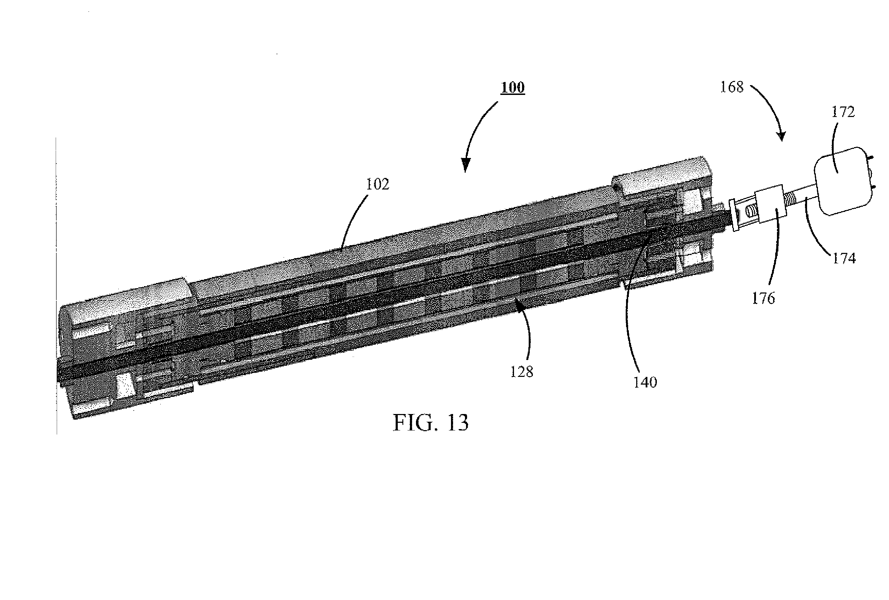

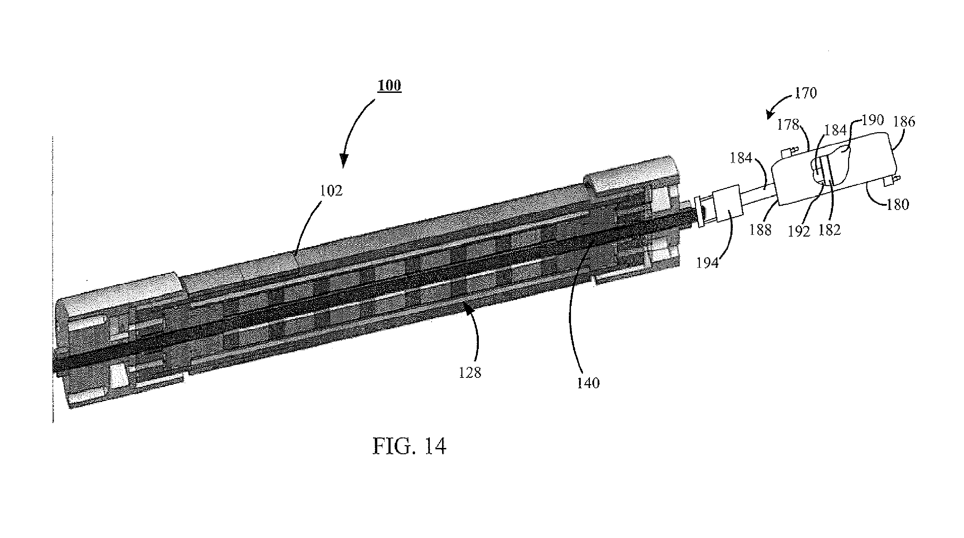

FIGS. 13 and 14 show alternate preferred embodiments of an actuator 168 and 170 respectively. The actuator 168 preferably includes at least an actuator motor 172, communicating with a screw drive 174, and an end effecter 176 that is coupled to the magnet assembly 128 and the end effecter 176. In a preferred embodiment, an activation of the actuator motor 172, imparts a rotation of the screw drive 174. The rotation of the screw drive 174 translated to a linear motion of the end effecter 176, which shifts the position of the magnet assembly 128, internal to the cathode 102. Preferably, the actuator motor 172 is a direct current motor, but could alternatively be a pneumatic motor, a rotary hydraulic motor, a stepper motor, or other rotational output type of motor.

The actuator 170, of FIG. 14, preferably includes at least a fluidic cylinder 178, preferably the fluidic cylinder 178 includes at least a cylinder barrel 180, in which a piston 182 is connected to a piston rod 184 that moves back and forth. The cylinder barrel 180 is preferably closed on one end by the cylinder bottom 186 (also called the cap 186) and the other end by the cylinder head 188 (also called the gland 188) where the piston rod 184, comes out of the cylinder barrel 180. In a preferred embodiment, the piston 182 has sliding rings and seals. The piston 182, divides the inside of the cylinder barrel 180 into two chambers, the bottom chamber 190 (cap 186 end) and the piston rod side chamber 192 (rod end / cylinder head 188 end). In a preferred embodiment, the piston rod 184, communicates with an end effecter 194 that is coupled to the magnet assembly 128. Preferably, an activation of the fluidic cylinder 178 imparts a linear motion on the piston rod 184. The linear motion of the piston rod 184 translated to a linear motion of the end effecter 194, which shifts the position of the magnet assembly 128, internal to the cathode 102.

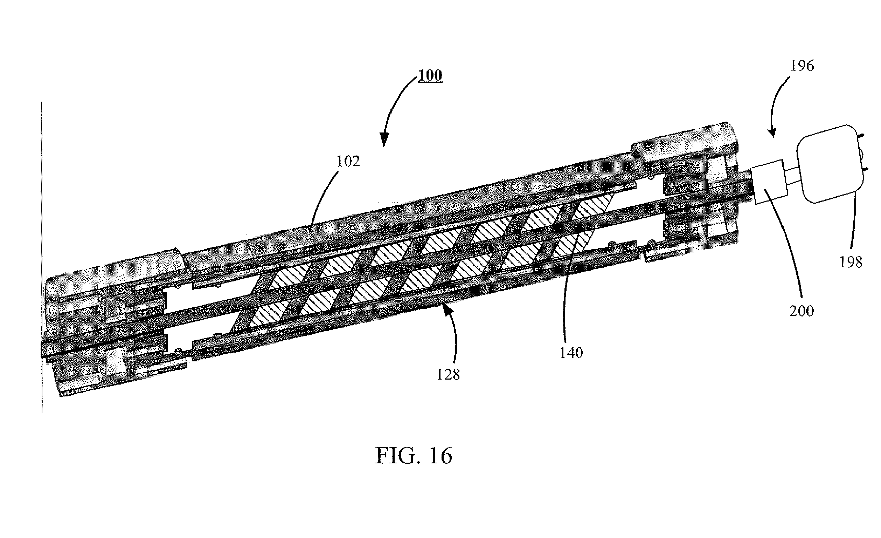

FIG. 16 shows an additional alternate preferred embodiment of an actuator 196, which preferably includes at least an actuator motor 198, communicating with a load adapter 200. Preferably, the load adapter 200 is disposed between and coupled to the actuator motor 198 and the magnet assembly 128. In a preferred embodiment, an activation of the actuator motor 198, imparts a rotation of the load adapter 200, which translates a rotational motion to the magnet assembly 128 that rotates the position of the magnet assembly 128, internal to the cathode 102. Preferably, the actuator motor 198 is a direct current motor, but could alternatively be a pneumatic motor, a rotary hydraulic motor, a stepper motor, or other rotational output type of motor.

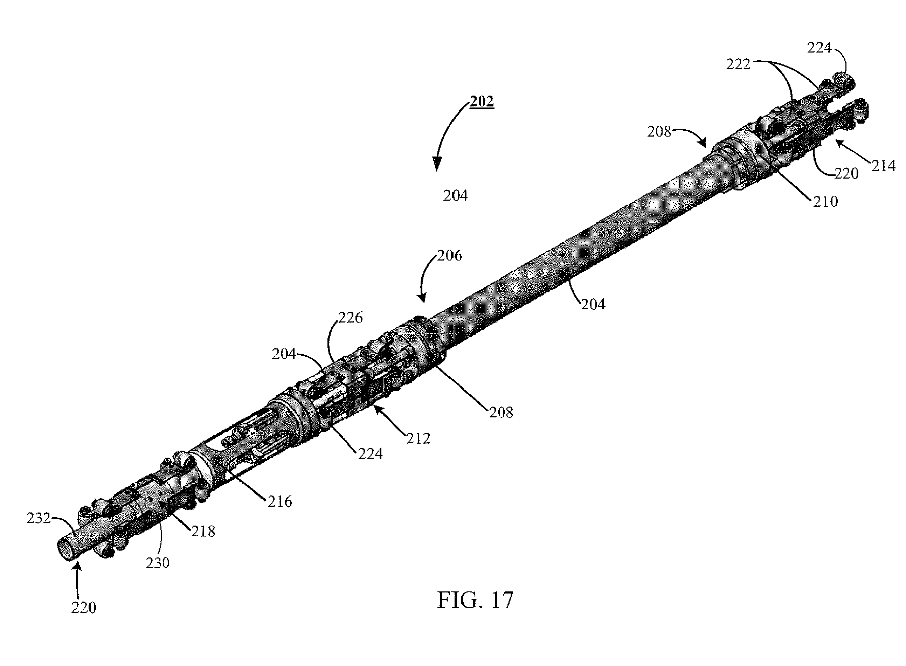

FIG. 17, displays an alternate exemplary sputtering apparatus 202 which includes at least a cathode 204, preferably formed from copper, which provides a first end 206, and a second end 208. In a preferred embodiment, the sputtering apparatus 202 further includes a supply side cap 208 affixed to first end 204 of the cathode 204, and a return side cap 210 affixed to the second end 208 of the cathode 204, wherein the supply side cap 208, the return side cap 210, and the cathode 204 share a common electrical potential.

Preferably, the alternate exemplary sputtering apparatus 202 further includes, a cathode inlet guide mechanism 212, supporting the cathode 204 on the first end 206, a cathode outlet guide mechanism 214, supporting the cathode 204 on the second end 208, a cable outlet weldment 216, secured to the cathode inlet guide mechanism 212, and a cable bundle guide mechanism 218, attached to the cable outlet weldment 216. Preferably, the cable bundle guide mechanism 218, maintains an alignment of a cable bundle 220 relative to the cathode 204.

As further shown by FIG. 17, the guide mechanisms 212, 214, and 218, of the alternate exemplary sputtering apparatus 202, provides a plurality of carriages 222, each supporting a rotational mechanism 224. Preferably: the carriages 222, of the cathode inlet guide mechanism 212, are secured to an inlet guide main housing 226, of the cathode inlet guide mechanism 212; the carriages 222, of the cathode outlet guide mechanism 214, are secured to an outlet guide main housing 228, of the cathode outlet guide mechanism 214; and the carriages 222, of the cable bundle guide mechanism 218, are secured to a conduit confinement member 230, of the the cable bundle guide mechanism 218. Preferably, the cable bundle 220, is housed within a conduit 232, and the conduit confinement member 230 secures the conduit 232.

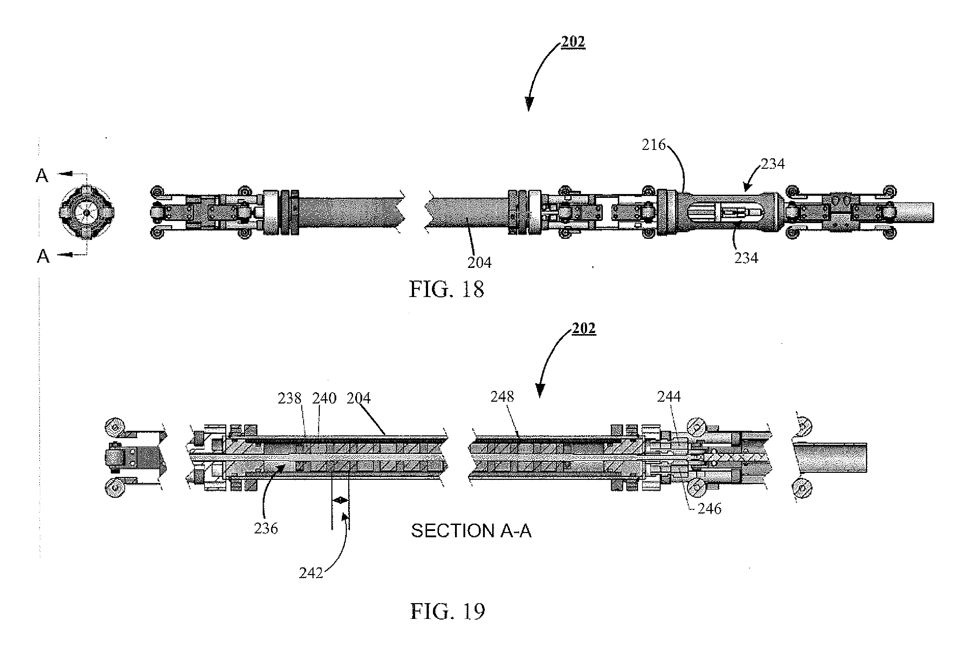

FIG. 18, shows the cable outlet weldment 216, of the alternate exemplary sputtering apparatus 202, provides at least one maintenance access aperture 234, which is used to access the cable bundle 220, for attachment of the cable bundle 220 to the cathode 202. FIG. 19, reveals that a magnetron 236, is preferably formed from a plurality of magnet 238, separated by a plurality of to the insulators 240, and that a space between each of the plurality of magnets 238 and occupied by an insulator of the plurality of insulators 240, is a magnet pitch 242.

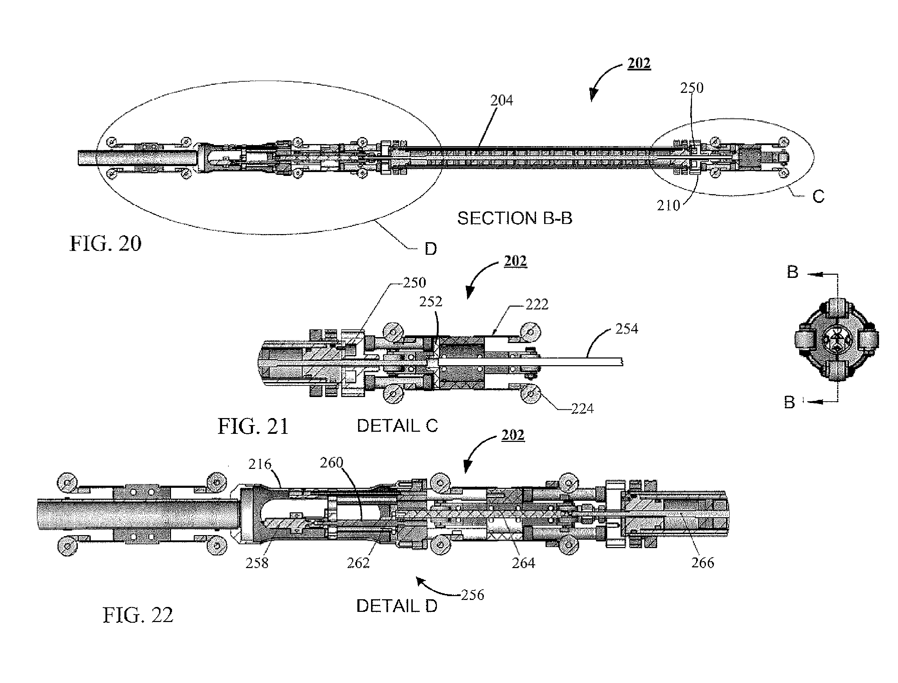

FIG. 19, shows that the alternate exemplary sputtering apparatus 202, further preferably provides a coolant supply conduit 244, a coolant return 246, and a coolant path 248, disposed between the cathode 204 and the magnetron 236. FIG. 20 reveals that the return side cap 210, of the cathode 204, provides a coolant return cavity 250, while FIG. 21 reveals that the guide mechanism 212, preferably includes a guide wire attachment member 252, which secures a guide wire 254.

FIG. 22, shows an actuator 256, preferably includes at least a linear actuator 258, preferably selected from a group consisting of a direct current motor, a fluidic cylinder, a fluidic motor, and a voice coil. In a preferred embodiment, the linear actuator 258 is housed by the cable outlet weldment 216, and further includes: a lead screw 260 communicating with the linear actuator 258, and housed by the cable outlet weldment 216; a lead screw nut 262, interacting with the lead screw 260, and housed by the cable outlet weldment 216; a magnet pull rod 264, attached to the lead screw nut 262, and housed by the inlet guide main housing 226; and a magnet guide rod 266, disposed between and secured to the magnet pull rod 264 and the magnetron 236.

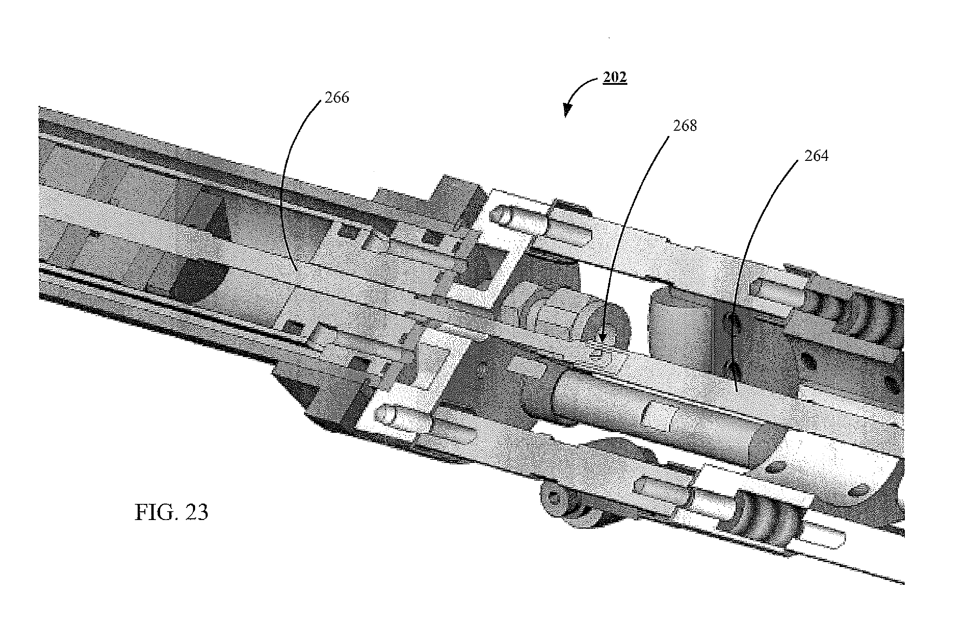

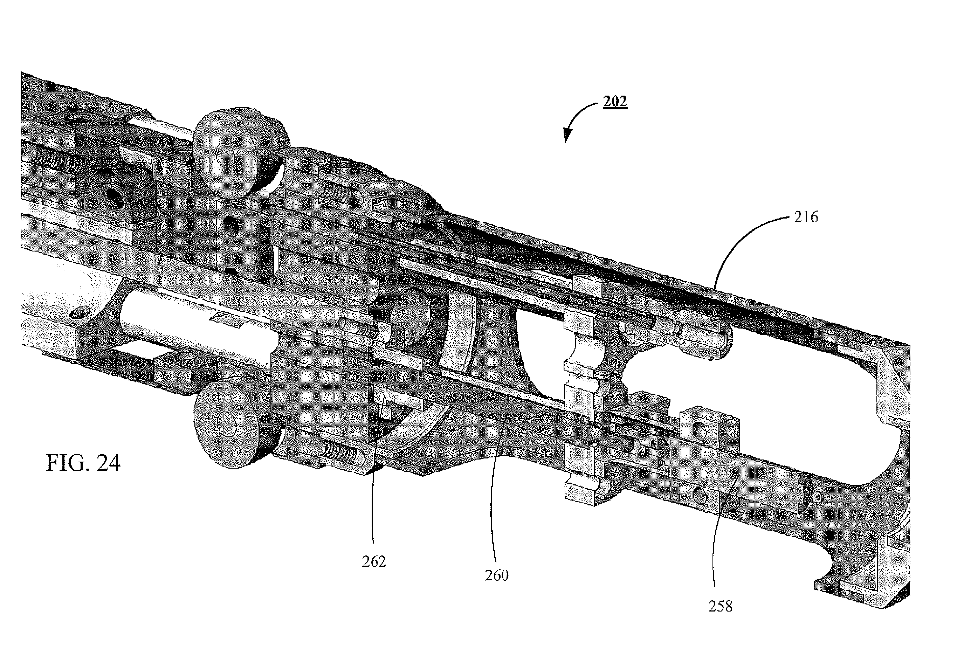

FIG. 23 provides a close-up view of the magnet pull rod 264, joined to the magnet guide rod 266, by an attachment structure 268, and FIG. 24 shows a close-up view of the linear actuator 258 is housed by the cable outlet weldment 216, communicating with the lead screw 260, and the lead screw nut 262, interacting with the lead screw 260.

It is to be understood that even though numerous characteristics and advantages of various embodiments of the present invention have been set forth in the foregoing description, together with details of the structure and function of various embodiments of the invention, this detailed description is illustrative only, and changes may be made in detail, especially in matters of structure and arrangements of parts within the principles of the present claimed invention to the full extent indicated by the broad general meaning of the terms in which the appended claims are expressed. For example, the particular elements may vary depending on the particular application without departing from the spirit and scope of the present claimed invention.

It will be clear that the present invention is well adapted to attain the ends and advantages mentioned as well as those inherent therein. While presently preferred embodiments have been described for purposes of this disclosure, numerous changes may be made which will readily suggest themselves to those skilled in the art and which are encompassed by the appended claims.

The present invention will now be described by way of reference to the following clauses:
1. A sputtering apparatus comprising:
   a target presented as an inner surface of a confinement structure;
   a cathode adjacent the target, the cathode providing a hollow core, a first end, and a second end;
   a magnetron disposed within the hollow core;
   an actuator communicating with the magnetron, wherein a position of the magnetron within the hollow core is altered upon activation of the actuator;
   a cathode inlet guide mechanism supporting the cathode on the first end and communicating with the target;
   a cathode outlet guide mechanism supporting the cathode on the second end and communicating with the target;
   a cable bundle interacting with the cathode; and
   a cable bundle take up mechanism secured to the cable bundle.
2. The sputtering apparatus of clause 1, further comprising:
   a cable outlet weldment secured to the cathode inlet guide mechanism; and
   a cable bundle guide mechanism attached to the cable outlet weldment, the cable bundle guide mechanism maintains an alignment of the cable bundle relative to the cathode.
3. The sputtering apparatus of clause 2, in which the cathode inlet guide mechanism comprising:
   an inlet guide main housing; and
   at least one carriage secured to the inlet guide main housing.
4. The sputtering apparatus of clause 3, in which the at least one carriage secured to the inlet guide main housing comprising:
   a flexure secured to the inlet guide main housing; and
   a rotational mechanisms affixed to the flexure.
5. The sputtering apparatus of clause 4, in which the cathode outlet guide mechanism comprising:
   an outlet guide main housing; and
   at least one carriage secured to the outlet guide main housing.
6. The sputtering apparatus of clause 5, in which the at least one carriage secured to the outlet guide main housing comprising:
   a flexure secured to the outlet guide main housing; and
   a rotational mechanisms affixed to the flexure.
7. The sputtering apparatus of clause 6, in which the actuator comprises:
   a linear actuator housed by the cable outlet weldment;
   a lead screw communicating with the linear actuator and housed by the cable outlet weldment;
   a lead screw nut interacting with the lead screw, and housed by the cable outlet weldment;
   a magnet pull rod attached to the lead screw nut, and housed by the inlet guide main housing; and
   a magnet guide rod disposed between and secured to the magnet pull rod and the magnetron.
8. The sputtering apparatus of clause 7, further comprising, a conduit enclosing the cable bundle, a conduit securement member cooperating with the conduit and attached to the cable outlet weldment, and in which the cable bundle guide mechanism comprises:
   a conduit confinement member confining the conduit; and
   at least one carriage secured to the conduit confinement member.
9. The sputtering apparatus of clause 8, in which the at least one carriage secured to the conduit confinement member comprising:
   a flexure secured to the conduit confinement member; and
   a rotational mechanisms affixed to the flexure.
10. The sputtering apparatus of clause 1, in which the magnetron comprising:
   a plurality of magnets each have a pair of substantially parallel external side surfaces;
   each of the plurality of magnets providing a main body portion disposed between the pair of substantially parallel external side surfaces, the main body portion having an external surface disposed between and substantially perpendicular to the pair of substantially parallel external surfaces; and
   a plurality of insulators disposed between each of the plurality of magnets, wherein a space between each of the plurality of magnets and occupied by an insulator of the plurality of insulators a magnet pitch, and in which the linear actuator moves the magnetron by not less than the magnet pitch.
11. The sputtering apparatus of clause 10, further comprising:
   a supply side cap affixed to first end of the cathode; and
   a return side cap affixed to the second end of the cathode, wherein the supply side cap, the return side cap, and the cathode share a common electrical potential.
12. The sputtering apparatus of clause 11, in which the plurality of magnets each have a substantially circular cross section, and the the confinement structure presents an elongated cylinder.
13. The sputtering apparatus of clause 7, in which the linear actuator moves the magnetron in a linear path substantially parallel to the inner surface of a confinement structure.
14. The sputtering apparatus of clause 13, in which the linear actuator is selected from a group consisting of a direct current motor, a fluidic cylinder, a fluidic motor, and a voice coil.
15. The sputtering apparatus of clause 1, further comprising a coolant channel disposed between an external surface of the magnetron and an internal surface of the cathode.
16. The sputtering apparatus of clause 1, in which the cable bundle comprises a coolant line adjacent power conductors, the coolant line and power conductors enclosed by a conduit.
17. The sputtering apparatus of clause 1, in which the rotational mechanisms affixed to the flexure supports the cathode a predetermined distance from the target.
18. The sputtering apparatus of clause 17, in which the predetermined distance the cathode is supported from the target is not greater than four centimeters, and in which the rotational mechanism is a wheel mounted on a spring suspension.
19. The sputtering apparatus of clause 18, in which the cable bundle take up mechanism comprises:
   a spool communicating with the conduit;
   a motor cooperating with the spool;
   a motor controller communicating with the motor;
   a cabinet housing the motor and spool;
   a conduit guide and tensioning mechanism interacting with the conduit, the cabinet, and the spool; and
   an operator interface including at least a monitor and keyboard interfacing with the motor controller.
20. A method by steps comprising:
   providing a target presented as an inner surface of a confinement structure;
   supplying a cathode adjacent the target, the cathode providing a hollow core, a first end, and a second end;
   disposing a magnetron within the hollow core;
   affixing an actuator communicating to the magnetron, wherein a position of the magnetron within the hollow core is altered upon activation of the actuator;
   supporting the cathode with a cathode inlet guide mechanism, the cathode inlet guide supporting the cathode on the first end and communicating with the target;
   supporting the cathode with a cathode outlet guide mechanism, the cathode outlet mechanism supporting the cathode on the second end and communicating with the target;
   providing a cable bundle interacting with the cathode; and
   supplying a cable bundle take up mechanism secured to the cable bundle, to form a sputtering apparatus.

## Claims

1. A sputtering apparatus comprising:
a target presented as an inner surface of a confinement structure;
a cathode adjacent the target, the cathode providing a hollow core, a first end, and a second end;
a magnetron disposed within the hollow core;
an actuator communicating with the magnetron, wherein a position of the magnetron within the hollow core is altered upon activation of the actuator;
a cathode inlet guide mechanism supporting the cathode on the first end and communicating with the target;
a cathode outlet guide mechanism supporting the cathode on the second end and communicating with the target;
a cable bundle interacting with the cathode; and
a cable bundle take up mechanism secured to the cable bundle.

2. The sputtering apparatus of claim 1, further comprising:
a cable outlet weldment secured to the cathode inlet guide mechanism; and
a cable bundle guide mechanism attached to the cable outlet weldment, the cable bundle guide mechanism maintains an alignment of the cable bundle relative to the cathode.

3. The sputtering apparatus of claim 2, in which the cathode inlet guide mechanism comprising:
an inlet guide main housing; and
at least one carriage secured to the inlet guide main housing.

4. The sputtering apparatus of claim 3, in which the at least one carriage secured to the inlet guide main housing comprising:
a flexure secured to the inlet guide main housing; and
a rotational mechanisms affixed to the flexure.

5. The sputtering apparatus of claim 4, in which the cathode outlet guide mechanism comprising:
an outlet guide main housing; and
at least one carriage secured to the outlet guide main housing.

6. The sputtering apparatus of claim 5, in which the at least one carriage secured to the outlet guide main housing comprising:
a flexure secured to the outlet guide main housing; and
a rotational mechanisms affixed to the flexure.

7. The sputtering apparatus of claim 6, in which the actuator comprises:
a linear actuator housed by the cable outlet weldment;
a lead screw communicating with the linear actuator and housed by the cable outlet weldment;
a lead screw nut interacting with the lead screw, and housed by the cable outlet weldment;
a magnet pull rod attached to the lead screw nut, and housed by the inlet guide main housing; and
a magnet guide rod disposed between and secured to the magnet pull rod and the magnetron.

8. The sputtering apparatus of claim 7, further comprising, a conduit enclosing the cable bundle, a conduit securement member cooperating with the conduit and attached to the cable outlet weldment, and in which the cable bundle guide mechanism comprises:
a conduit confinement member confining the conduit; and
at least one carriage secured to the conduit confinement member.

9. The sputtering apparatus of claim 8, in which the at least one carriage secured to the conduit confinement member comprising:
a flexure secured to the conduit confinement member; and
a rotational mechanisms affixed to the flexure.

10. The sputtering apparatus of any of the preceding claims, in which the magnetron comprising:
a plurality of magnets each have a pair of substantially parallel external side surfaces;
each of the plurality of magnets providing a main body portion disposed between the pair of substantially parallel external side surfaces, the main body portion having an external surface disposed between and substantially perpendicular to the pair of substantially parallel external surfaces; and
a plurality of insulators disposed between each of the plurality of magnets, wherein a space between each of the plurality of magnets and occupied by an insulator of the plurality of insulators a magnet pitch, and in which the linear actuator moves the magnetron by not less than the magnet pitch; and
preferably further comprising:
a supply side cap affixed to first end of the cathode; and
a return side cap affixed to the second end of the cathode, wherein the supply side cap, the return side cap, and the cathode share a common electrical potential; and
wherein further preferably the plurality of magnets each have a substantially circular cross section, and the confinement structure presents an elongated cylinder.

11. The sputtering apparatus of claim 7, in which the linear actuator moves the magnetron in a linear path substantially parallel to the inner surface of a confinement structure; and
wherein preferably the linear actuator is selected from a group consisting of a direct current motor, a fluidic cylinder, a fluidic motor, and a voice coil.

12. The sputtering apparatus of any of the preceding claims, further comprising a coolant channel disposed between an external surface of the magnetron and an internal surface of the cathode; and
wherein preferably or alternatively the cable bundle comprises a coolant line adjacent power conductors, the coolant line and power conductors enclosed by a conduit.

13. The sputtering apparatus of claim 9, in which the rotational mechanisms affixed to the flexure supports the cathode a predetermined distance from the target; and
wherein preferably the predetermined distance the cathode is supported from the target is not greater than four centimeters, and in which the rotational mechanism is a wheel mounted on a spring suspension.

14. The sputtering apparatus of claim 13, in which the cable bundle take up mechanism comprises:
a spool communicating with the conduit;
a motor cooperating with the spool;
a motor controller communicating with the motor;
a cabinet housing the motor and spool;
a conduit guide and tensioning mechanism interacting with the conduit, the cabinet, and the spool; and
an operator interface including at least a monitor and keyboard interfacing with the motor controller.

15. A method by steps comprising:
providing a target presented as an inner surface of a confinement structure;
supplying a cathode adjacent the target, the cathode providing a hollow core, a first end, and a second end;
disposing a magnetron within the hollow core;
affixing an actuator communicating to the magnetron, wherein a position of the magnetron within the hollow core is altered upon activation of the actuator;
supporting the cathode with a cathode inlet guide mechanism, the cathode inlet guide supporting the cathode on the first end and communicating with the target;
supporting the cathode with a cathode outlet guide mechanism, the cathode outlet mechanism supporting the cathode on the second end and communicating with the target;
providing a cable bundle interacting with the cathode; and
supplying a cable bundle take up mechanism secured to the cable bundle, to form a sputtering apparatus.
